# EUROPEAN PATENT SPECIFICATION

(11) **EP 2 796 019 B1**
(45) Date of publication and mention of the grant of the patent: **04.01.2017**
(21) Application number: 12805956.5
(22) Date of filing: 27.11.2012
(51) Int. Cl.: H05K 3/42, C25D 3/38, H01L 21/288, C23C 18/16, C25D 7/12, C25D 5/18

(54) **METHOD FOR COMBINED THROUGH-HOLE PLATING AND VIA FILLING**
VERFAHREN FÜR KOMBINIERTE DURCHKONTAKTIERUNG UND KONTAKTLOCHFÜLLUNG
PROCÉDÉ DE PLACAGE DE TROUS TRAVERSANTS ET DE REMPLISSAGE DE TRAVERSÉES COMBINÉS

(30) Priority: 21.12.2011 CN 201110463131
(43) Date of publication of application: 29.10.2014
(73) Proprietor: Atotech Deutschland GmbH, 10553 Berlin (DE)
(72) Inventor: MIRKOVIC, Marko, 10825 Berlin (DE); KLOBUS, Marcin, 10317 Berlin (DE); TONG, Terry, Shanghai, 201108 (CN); CHEN, Ted, Shanghai 201401 (CN); TANG, Tiger, Shanghai 201401 (CN); MOSER, Christoph, A-4400 Steyr (AT)
(86) International application number: PCT/EP2012/073727
(87) International publication number: WO 2013/092131

(56) References cited:
- US-A- 3 873 429
- US-A1- 2003 010 642
- US-A1- 2006 151 328
- US-A1- 2009 301 889
- US-A1- 2011 011 746
- US-B1- 6 541 712

## Description

### Field of the Invention

The present invention relates to a copper electroplating method for combined through-hole plating and blind micro via filling in the manufacture of printed circuit boards, IC substrates and the like. Such a method is disclosed in US 2003/0010642 A1.

### Background of the Invention

Electroplating of copper is a common technique in the manufacture of electronic components such as printed circuit boards and IC substrates. Different types of structures in a multilayer laminate such as through-holes (THs) need to be conformally plated with copper whereas for example blind micro vias (BMVs) need to be completely filled with copper.

Different methods for said purpose are known in the art:
A first method utilizing vertical plating equipment comprises the steps of a) TH and BMV formation, b) flash plating, c) conformal plating of THs and filling of BMVs and d) reducing the copper layer thickness on top of the substrate. The disadvantage of said method is a high thickness of the copper layer conformally plated onto the top surface of the multilayer laminate and the walls of THs: Hence, subsequent reduction (e.g., by etching, grinding, brushing or pumice) steps of the copper layer on the top surface of the multilayer laminate is required to facilitate fine line etching.

Two other methods utilizing horizontal plating equipment are known in the art. The first method comprises the steps of a) TH and BMV formation, b) flash plating, c) conformal plating of THs, d) filling of BMVs, e) panel plating and f) reducing the copper layer thickness on top of the multilayer laminate. The disadvantages of said method are an incomplete filling of BMVs located near THs and an insufficient plated copper layer thickness of THs, mainly in the entrance area of THs. If a higher plated copper layer thickness in THs should be achieved, the thickness of the simultaneously plated copper layer on the top surface of the multilayer laminate is too high for etching of fine lines (≤ 75 µm copper line width and inter-line distance are considered herein as fine lines).

The second method utilizing horizontal plating equipment known in prior art separates the steps of conformal TH plating and filling of BMVs. Said second method comprises the steps of a) BMV formation, b) first flash plating, c) BMV filling, d) thickness reduction of the plated copper layer on the top surface of the multilayer laminate, e) TH formation, f) second flash plating and g) conformal TH plating. The high number of process steps results in higher process costs and a high thickness variation of the plated copper layer on the top surface of the multilayer laminate. Hence, etching of fine copper lines on the top surface of the multilayer laminate is complicated and result in even higher process costs. The registration systems used for BMV formation and TH formation have to be separated resulting in an inferior alignment of BMVs and THs to each other. Furthermore, production yields are lowered due to the separation of registration systems for BMV and TH formation.

Hence, a combination of known methods for conformal plating of THs and filling of BMVs requires a large number of process steps and, hence, is expensive and leads to low yields. Furthermore, the thickness of copper deposited onto the top surface of the multilayer laminate is too thick for generation of fine line circuitry in successive manufacturing steps. A multilayer laminate comprises a dielectric core layer and one to twelve dielectric layers which are attached to the dielectric core layer to both sides of the dielectric core layer. All dielectric layers contain a copper layer on each side.

### Objective of the present Invention

Therefore, it is the objective of the present invention to provide a copper electroplating method for filling blind micro vias and conformal plating of THs in one step wherein the copper deposited onto the top surface of the multilayer laminate allows generation of fine line circuitry in successive manufacturing steps.

### Summary of the Invention

This objective is solved by a method of copper electroplating in the manufacture of printed circuit boards and IC substrates according to claim 1.

The aqueous acidic copper plating bath used in step d. comprises 12 to 20 g/l ferrous ions.

The multilayer laminate is processed in horizontal plating equipment that is typically used for continuous panel plating or via filling. The process parameters utilized in step d. comprise distinct concentration ranges for certain ingredients of the aqueous acidic copper plating bath. Said concentration ranges are set for the concentration of copper ions, iron ions (both ferrous and ferric), brightener additives and leveller additives. The most important concentration range to be set is the concentration of ferrous ions. The process parameters utilized in step d. also comprise current settings for pulsed plating including forward and reverse peak currents as well as pulse time setting.

Filling of blind micro vias and conformal plating of through-holes in one step is feasible with the method according to the present invention. "One step" is defined here as one plater pass, i.e. the multilayer laminate to be plated is conveyorized once through the horizontal plating equipment. "Two steps" is defined as two separate plater passes, i.e., a multilayer laminate is conveyorized two times through the plating equipment. In comparison with methods known in the art incomplete blind micro via filling, indicated by a dimple, is reduced to an acceptable level for further processing of printed circuit boards or IC substrates, including soldering of via-in-pad designs. The throwing power (ratio of plated copper thickness on top of the substrate surface and inside the through-hole) is sufficient to achieve the required copper layer thickness inside the through-hole while maintaining a plated copper layer thickness on the top surface of the multilayer laminate which allows etching of fine copper lines (≤ 75 µm copper line width and inter-line distance).

Furthermore, the number of process steps is reduced in comparison with known methods. A single registration system required for both through-hole and blind micro via formation can be used which results in better production yields.

### Brief Description of the Drawings

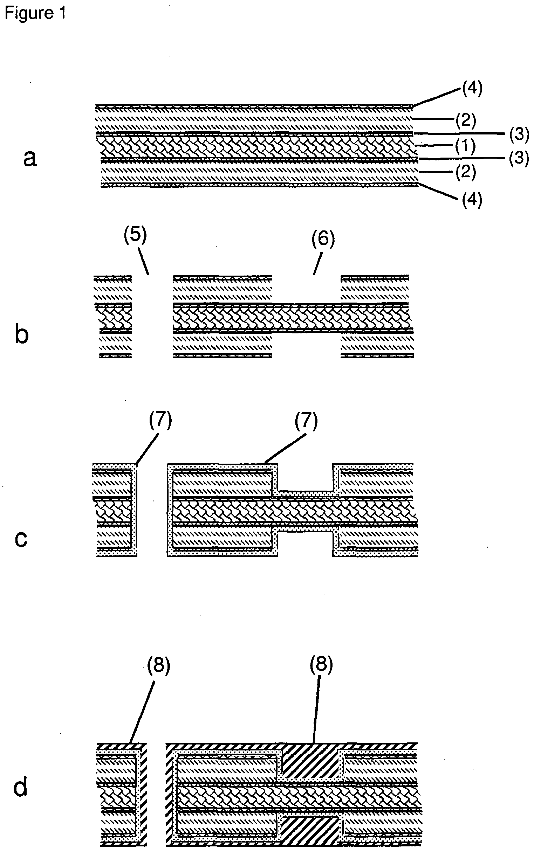

Fig. 1 shows steps a. to d. of the method according to the present invention.

### Detailed Description of the Invention

The method according to the present invention is shown in Figure 1.

The figure shown herein is simply illustrative of the method according to the present invention. The figure is not drawn to scale, i.e. it does not reflect the actual dimensions or features of the various layers. Like numbers refer to like elements throughout the description.

A multilayer laminate comprising a dielectric core layer (1) is provided (Fig. 1 a). Two copper layers (3) is attached to each side of the dielectric core layer (1). At least one dielectric outer layer (2) is attached to said inner copper layers (3). An outer copper layer (4) is attached to the other side of the at least one dielectric inner layer (2).

Such a multilayer laminate may comprises the same number or different numbers of dielectric outer layers (2) and outer copper layers (4) attached on both sides of the inner copper layers (3).

Such a multilayer laminate may comprises one to eight or even up to twelve dielectric outer layers (2) and the same number of outer copper layers (4) attached on each of the two inner copper layers (3). A multilayer laminate consisting of a dielectric core layer (1), two inner copper layers (3) on each side thereof, one dielectric outer layer (2) attached on each side of said inner copper layers (3) and one outer copper layer (4) attached to both dielectric outer layers (2) is shown in Figure 1.

Through-holes (5) extend through the whole multilayer laminate. Blind micro vias (6) extend through at least to the outermost copper layer (4) and the outermost dielectric inner layer (2).

In a preferred embodiment of the present invention the through-holes (5) have a maximum height of 3.5 mm, a preferred height of 0.025 to 1 mm and a particularly preferred height of 0.05 to 0.5 mm as well as a diameter of 0.04 to 6 mm, a preferred diameter of 0.05 to 4 mm and a particularly preferred diameter of 0.06 to 2 mm. Alternatively or in addition to through-holes (5), slot holes may be present at similar diameters as the through-holes (5) and lengths. The slot holes can be linear, L, T or cross shaped or in any other geometric shapes. The blind micro vias (6) have a maximum height of 0.5 mm, a preferred height of 0:010 to 0.150 mm and a particularly preferred height of 0.035 to 0.070 mm as well as a diameter of 0.5 mm at the most, preferably 0.02 to 0.15 mm and particular preferred 0.04 to 0.11 mm.

Through-holes (5), blind micro vias (6) and slot holes can be formed by methods such as mechanical drilling, laser drilling, plasma etching and spark erosion. Preferably, through-holes (5) are formed by mechanical drilling and blind micro vias (6) are formed by laser drilling (Figure 1 b).

In order to electroplate copper on a non-conductive surface, a conductive seed layer formed on the non-conductive surface is required to initiate the electroplating of copper. In general, the seed layer is for example formed by electroless deposition of copper. The seed metal layer is electrically conductive, provides adhesion and permits the exposed portions of its upper surface to be electroplated.

The dielectric walls of through-holes (5), blind micro vias (6) and slot holes are subjected to a cleaning process in order to remove smear and other residues derived from methods such as mechanical drilling, laser drilling, plasma etching and spark erosion. The cleaning process can be either a wet chemical desmear or a plasma desmear process. Such methods are known in the art (e.g.: C. F. Coombs, Jr., "Printed Circuits Handbook", 5th Ed. 2001, Chapter 28.4, pages 28.5 to 28.7).

A wet chemical desmear process comprises the steps of a) swelling the dielectric surfaces of the dielectric layers, b) etching the dielectric surfaces of the dielectric layers with a permanganate solution and c) removing MnO₂ from the dielectric surfaces of the dielectric layers by reducing.

Next, the dielectric surface of the through-holes (5), blind micro vias (6) and slot holes is activated by conventional methods such as electroless plating of copper or by a direct plating method. Such methods are also known in the art (e.g.: C. F. Coombs, Jr., "Printed Circuits Handbook", 5th Ed. 2001, Chapter 28.5, pages 28.7 to 28.10).

Flash plating of copper is then required for the electroplating in step d. A thin layer of copper (7) having a thickness ≤ 0.1 µm is deposited during flash plating in step c. onto the whole surface of the multilayer substrate. This is shown in Figure 1 c. Such a thin flash plated copper layer (7) provides a smooth surface and a sufficient electrical conductivity for successive electroplating of copper in step d. Furthermore, the flash plated copper layer (7) reinforces the copper layer deposited by electroless plating. A high current density and a low copper ion concentration in a conventional aqueous acidic copper plating bath are utilized for flash plating. DC, AC and pulse plating can be used for flash plating in step c.

Next, copper (8) is deposited by electroplating onto the surface of the through-holes (5) and into the blind micro vias (6) in step d. (Figure 1 d).

In general, any aqueous acidic copper plating bath comprising the metal ion redox system disclosed in claim 1 and organic leveller and brightener additives, preferably in combination with inert anodes can be utilized in step d.

The use of a metal ion redox system in the plating bath is necessary in the copper electroplating method according to the present invention and is a redox system consisting of ferrous and ferric ions: 12 to 20 g/l of ferrous ions are present in the plating bath and the concentration of ferric ions in the plating bath ranges from 2 to 6 g/l.

The redox couple consisting of ferrous and ferric ions is also automatically formed if only ferrous ions are added to the acidic copper plating bath composition.

The organic brightener additives are selected from sulfur containing compounds such as thiol-, sulfide-, disulfide- and polysulfide-compounds (US 4,975,159). Preferred brightener additives are selected from the group comprising 3-(benzthiazolyl-2-thio)-propylsulfonic-acid, 3-mercaptopropan-1-sulfonic-acid, ethylendithiodipropylsulfonic-acid, bis-(p-sulfophenyl)-disulfide, bis-(ω-sulfobutyl)-disulfide, bis-(ω-sulfohydroxypropyl)-disulfide, bis-(ω-sulfopropyl)-disulfide, bis-(ω-sulfopropyl)-sulfide, methyl-(ω-sulfopropyl)-disulfide, methyt-(ω-sulfopropyl)-trisulfide, O-ethyl-dithiocarbonic-acid-S-(ω-sulfopropyl)-ester, thio-glycol-acid, thiophosphoric-acid-O-ethyl-bis-(ω-sulfopropyl)-ester, thiophosphoric-acid-tris-(ω-sulfopropyl)-ester and their corresponding salts. The concentration of the brightener additive present in the aqueous acidic copper bath ranges from 0.01 mg/l to 100 mg/l, more preferably from 0.05 to 50 mg/l and most preferably from 0.1 to 10 mg/l.

The aqueous acidic copper plating bath contains in addition to the at least one brightener additive at least one leveller additive selected from the group comprising nitrogen containing organic compounds such as polyethyleneimine, alkoxylated polyethyleneimine, alkoxylated caprolactames and polymers thereof, polyvinylpyrrole, diethylenetriamine and hexamethylenetetramine, organic dyes such as Janus Green B, Bismarck Brown Y, phenazonium dyes, malachite green, rosalinine, crystal violet and Acid Violet 7, sulfur containing amino acids such as cysteine, phenazinium salts and derivatives thereof. Said leveller additive compounds are added to the copper plating bath in amounts of 0.1 mg/l to 100 mg/l, more preferably from 0.2 to 50 mg/l and most preferably from 0.5 to 10 mg/l.

Copper ions are added to the plating bath as a water-soluble copper salt. Preferably, the source of copper ions is selected form copper sulfate pentahydrate, a copper sulfate solution or copper methane sulfonate. The concentration of copper ions ranges from 15 to 75 g/l, more preferably from 40 to 60 g/l.

When using inert anodes, copper ions are replenished during use of the acidic copper ions by dissolving metallic copper by oxidation in the presence of ferric ions in a separate container ("copper ion generator") connected to the plating equipment. Metallic copper can be for example provided in the form of pellets, pieces and spheres. At the same time, ferric ions are reduced to ferrous ions. Both copper ions and ferrous ions are returned to the plating equipment using pumps.

The at least one source of acid is selected from the group comprising sulfuric acid, fluoro boric acid and methane sulfonic acid. The concentration of the at least one acid ranges from 20 to 400 g/l and more preferably from 40 to 300 g/l.

In case sulfuric acid is used as an acid, it is added in form of a 50 to 96 wt.-% solution. Most preferably, 85 to 120 g/l of a 50 wt.-% solution of sulfuric acid is added to the plating bath.

The acidic copper plating bath may further contains at least one carrier additive which is usually a polyalkylenglycol compound (US 4,975,159) and is selected from the group comprising polyvinylalcohol, carboxymethylcellulose, polyethylenglycol, polypropylenglycol, stearic acid polyglycolester, oleic acid polyglycolester, stearylalcoholpolyglycolether, nonylphenolpolyglycolether, octanolpolyalkylenglycolether, octanediol-bis-(polyalkylenglycolether), poly(ethylenglycolran-propylenglycol), poly(ethylenglycol)-*block*-poly(propylenglycol)-*block-*poly(ethylenglycol), poly(propylenglycol)-*block*-poly(ethylenglycol)-*block-*poly(propylenglycol). The concentration of said carrier additives ranges from 0.005 g/l to 20 g/l, more preferably from 0.01 g/l to 5 g/l.

Chloride ions may be added to the acidic copper plating bath in the form of sodium chloride or as diluted hydrochloric acid. The concentration of chloride ions in the plating bath ranges from 20 to 200 mg/l, preferably 30 to 100 mg/l and most preferably from 35 to 75 mg/l.

Both inert anodes and soluble anodes can be used as anodes in step d. Preferably, at least one inert anode is used. Suitable inert anodes are for example titanium anodes coated with iridium oxides.

In step d. of the method according to the present invention, the following parameters for pulse reverse plating are adjusted:
First, a first cycle comprising at least one first forward pulse and at least one first reverse pulse is applied to the multilayer laminate:
   The at least one first forward pulse applied has a peak current density in the range of 3 to 7 A/dm² and the at least one first reverse pulse has a peak current density in the range of 20 to 40 A/dm². The duration of the first cycle is preferably set in the range of 20 to 160 ms. The duration of the at least one first forward pulse is set in the range of 2 to 40 ms. The duration of the at least one first reverse pulse is set in the range of 2 to 8 ms.

Next, in the same plater pass, a second cycle comprising at least one forward pulse and at least one reverse pulse is applied to the substrate:
The at least one forward pulse in the second cycle has preferably a peak current density in the range of 4 to 10 A/dm² and the at least one reverse pulse in the second cycle has preferably a peak current density in the range of 0 to 20 A/dm². The duration of the second cycle is preferably set in the range of 2 to 160 ms. The duration of the at least one forward pulse in the second cycle is in the range of 2 to 40 ms. The duration of the at least one reverse pulse in the second cycle is in the range of 1 to 4 ms.

In one embodiment of the present invention, at least one plating module comprising a system of segmented inert anodes is used in step d.

The present invention is further explained by the following non-limiting example.

### Example

A multilayer laminate as shown in Figure 1 having through-holes (5) and blind micro vias (6) is subjected to the copper electroplating method according to the present invention. The through-holes (5) have a diameter of 0.4 mm and a depth of 0.8 mm. The blind micro vias (6) have a nominal diameter of 90 µm and a depth of 60 µm. Through-holes (5) are formed by mechanical drilling. Blind micro vias (6) are formed by laser drilling with a CO₂ laser.

The through-holes (5) and blind micro vias (6) formed in step a. are treated by methods known in the art for successive copper electroplating in step d.: a wet chemical desmear process and electroless deposition of copper onto the dielectric walls of the through-holes (5) and the blind micro vias (6) is performed.

Next, the copper layer deposited by electroless plating is thickened by flash plating (step c.) to form the first copper layer (7).

Step d., conformal through-hole plating and blind micro via filling with copper:
A horizontal plating module comprising a system of segmented anodes (UniPlate^{®} InPulse^{®} 2, manufactured by Atotech Deutschland GmbH) and an aqueous acidic copper plating bath comprising 50 g/l copper ions, 1 mg/l organic brightener additive, 2 mg/l organic leveller additive, 500 mg/l organic carrier additive, 100 g/l of a 50 wt.-% sulfuric acid solution, 15 g/l ferrous ions and 4.5 g/l ferric ions is used.

The parameters for the pulse reverse plating consisting of a first cycle comprising a first forward pulse and a first reverse pulse and a second cycle comprising a forward pulse and a reverse pulse applied to the substrate in a single plater pass are selected as follows:

**First cycle:**

| | |
|---|---|
| Peak current density of first forward pulse | 5 A/dm² |
| Peak current density of first reverse pulse | 40 A/dm² |
| Duration of the first forward pulse | 10 ms |
| Duration of first reverse pulse | 4 ms |
| Duration of first cycle | 80 ms |

**Second cycle:**

| | |
|---|---|
| Peak current density of forward pulse | 8 A/dm² |
| Peak current density of reverse pulse | 40 A/dm² |
| Duration of the forward pulse | 10 ms |
| Duration of forward pulse | 2 ms |
| Duration of second cycle | 80 ms |

A multilayer laminate having through-holes (5) electroplated with a conformal copper layer (8) and blind micro vias (6) filled with copper (8) is obtained. The copper deposited on the top surface of the multilayer laminate has a thickness of 10 µm as determined by optical microscopy of a cross-sectioned sample.

The copper thickness of 10 µm plated on the top surface of the multilayer laminate makes the substrate suitable for making fine line etching in successive manufacturing steps.

## Claims

1. A method of copper electroplating in the manufacture of printed circuit boards and IC substrates comprising, in this order, the steps of
a. providing a multilayer laminate comprising a dielectric core layer (1) having an inner copper layer (3) attached to both sides thereon and at least one dielectric outer layer (2) attached to the inner copper layer (3) on both sides of the dielectric core layer (1), the at least one dielectric outer layer (2) having an outer copper layer (4) attached to the opposite side of the at least one dielectric outer layer (2),
b. forming at least one through-hole (5) and at least one blind micro via (6),
c. depositing a first copper layer (7) by flash plating and
d. filling the at least one blind micro via (6) and conformally plate the at least one through-hole (5) with copper (8) in one step,
wherein copper (8) is electroplated in step d. from an aqueous acidic copper plating bath comprising 12 to 20 g/l ferrous ions and 2 to 6 g/l ferric ions by pulse reverse plating comprising a first cycle of at least one forward pulse wherein the duration of the at least one first forward pulse is in the range of 2 to 40 ms and at least one reverse pulse wherein the duration of the at least one first reverse pulse is in the range of 2 to 8 ms and a second cycle of at least one forward pulse wherein the duration of the at least one forward pulse in the second cycle is in the range of 2 to 40 ms and at least one reverse pulse wherein the duration of the at least one reverse pulse in the second cycle is in the range of 1 to 4 ms applied in a single plater pass and wherein the pulse reverse plating parameters applied in step d. comprise in the first cycle a peak current density of at least one first forward pulse in the range of 3 to 7 A/dm² and a peak current density of at least one first reverse pulse in the range of 20 to 40 A/dm².

2. Method of copper plating according to claim 1 wherein copper (8) is electroplated in step d. from an aqueous acidic copper plating bath comprising
• a source of copper ions
• an acid
• at least one organic brightener additive
• at least one organic leveller additive
in the presence of at least one inert anode.

3. Method of copper plating according to claim 2 wherein the concentration of the at least one brightener additive ranges from 0.01 to 100 mg/l.

4. Method of copper plating according to any of claims 2 to 3 wherein the concentration of the at least one leveller additive ranges from 0.1 to 100 mg/l.

5. Method of copper plating according to any of the foregoing claims wherein the pulse reverse plating parameters applied in step d. further comprise in a second cycle a peak current density of at least one forward pulse in the range of 4 to 10 A/dm² and a peak current density of at least one reverse pulse in the range of 0 to 20 A/dm².

6. Method of copper plating according to any of the foregoing claims wherein the duration of the first cycle ranges from 20 to 160 ms.

7. Method of copper plating according to any of the foregoing claims wherein the duration of the second cycle ranges from 2 to 160 ms.

8. Method of copper plating according to any of the foregoing claims wherein through-holes and blind micro vias are formed in step b. by a method selected from mechanical drilling, laser drilling, plasma etching and spark erosion.

## Patentansprüche

1. Verfahren zum Kupfer-Elektroplattieren bei der Herstellung von gedruckten Schaltkreisplatten und IC-Substraten, umfassend, in dieser Reihenfolge, die folgenden Schritte
a. Bereitstellen eines Mehrschichtenlaminats, umfassend eine dielektrische Kernschicht (1) mit einer inneren Kupferschicht (3), angebracht an beide Seiten davon, und mindestens eine dielektrische äußere Schicht (2), angebracht an die innere Kupferschicht (3) an beiden Seiten der dielektrischen Kernschicht (1), wobei die mindestens eine dielektrische äußere Schicht (2) eine äußere Kupferschicht (4) aufweist, angebracht an die gegenüberliegende Seite der mindestens einen dielektrischen äußeren Schicht (2),
b. Bilden mindestens eines Durchgangslochs (5) und mindestens eines Mikro-Sacklochs (6),
c. Ablagern einer ersten Kupferschicht (7) durch Schnellplattieren und
d. Füllen des mindestens einen Mikro-Sacklochs (6) und konformes Plattieren des mindestens einen Durchgangslochs (5) mit Kupfer (8) in einem Schritt,
wobei Kupfer (8) in Schritt d. aus einem wässerigen sauren Kupferplattierungsbad, umfassend 12 bis 20 g/l zweiwertiger Eisen-Ionen und 2 bis 6 g/l dreiwertiger Eisen-Ionen, durch Pulsumkehrplattieren elektroplattiert wird, umfassend einen ersten Zyklus mindestens eines Vorwärtspulses, wobei die Dauer des mindestens einen ersten Vorwärtspulses im Bereich von 2 bis 40 ms liegt, und mindestens eines reversen Pulses, wobei die Dauer des mindestens einen ersten reversen Pulses im Bereich von 2 bis 8 ms liegt, und einen zweiten Zyklus mindestens eines Vorwärtspulses, wobei die Dauer des mindestens einen Vorwärtspulses in dem zweiten Zyklus im Bereich von 2 bis 40 ms liegt, und mindestens eines reversen Pulses, wobei die Dauer des mindestens einen reversen Pulses in dem zweiten Zyklus im Bereich von 1 bis 4 ms liegt, angewandt in einem einzelnen Plattierungsdurchgang, und wobei die in Schritt d. angewandten Pulsumkehrplattierungs-Parameter in dem ersten Zyklus eine Spitzenstromdichte mindestens eines ersten Vorwärtspulses im Bereich von 3 bis 7 A/dm² und eine Spitzenstromdichte mindestens eines ersten reversen Pulses im Bereich von 20 bis 40 A/dm² umfassen.

2. Verfahren zum Kupferplattieren nach Anspruch 1, wobei Kupfer (8) in Schritt d. aus einem wässerigen sauren Kupferplattierungsbad elektroplattiert wird, umfassend
o eine Quelle von Kupferionen
o eine Säure
o mindestens einen organischen Glanzzusatz
o mindestens einen organischen Einebnerzusatz in der Gegenwart mindestens einer inerten Anode.

3. Verfahren zum Kupferplattieren nach Anspruch 2, wobei die Konzentration des mindestens einen Glanzzusatzes von 0,01 bis 100 mg/l reicht.

4. Verfahren zum Kupferplattieren nach einem der Ansprüche 2 bis 3, wobei die Konzentration des mindestens einen Einebnerzusatzes von 0,1 bis 100 mg/l reicht.

5. Verfahren zum Kupferplattieren nach einem der vorstehenden Ansprüche, wobei die in Schritt d. angewandten Pulsumkehrplattierungs-Parameter ferner in einem zweiten Zyklus eine Spitzenstromdichte mindestens eines Vorwärtspulses im Bereich von 4 bis 10 A/dm² und eine Spitzenstromdichte mindestens eines reversen Pulses im Bereich von 0 bis 20 A/dm² umfassen.

6. Verfahren zum Kupferplattieren nach einem der vorstehenden Ansprüche, wobei die Dauer des ersten Zyklus von 20 bis 160 ms reicht.

7. Verfahren zum Kupferplattieren nach einem der vorstehenden Ansprüche, wobei die Dauer des zweiten Zyklus von 2 bis 160 ms reicht.

8. Verfahren zum Kupferplattieren nach einem der vorstehenden Ansprüche, wobei Durchgangslöcher und Mikro-Sacklöcher in Schritt b. durch ein Verfahren gebildet werden, ausgewählt aus mechanischem Bohren, Laserbohren, Plasmaätzen und Funkenerosion.

## Revendications

1. Procédé de cuivrage électrolytique dans la fabrication de cartes de circuits imprimés et de substrats IC comprenant, dans cet ordre, les étapes consistant à
a. se procurer un stratifié multicouche comprenant une couche diélectrique centrale (1) ayant sur elle une couche de cuivre interne (3) attachée aux deux côtés et au moins une couche diélectrique externe (2) attachée à la couche de cuivre interne (3) sur les deux côtés de la couche diélectrique centrale (1), l'au moins une couche diélectrique externe (2) ayant une couche de cuivre externe (4) attachée au côté opposé de l'au moins une couche diélectrique externe (2),
b. former au moins un trou traversant (5) et au moins un microtrou d'interconnexion borgne (6),
c. déposer une première couche de cuivre (7) par revêtement-flash et
d. remplir l'au moins un microtrou d'interconnexion borgne (6) et recouvrir de façon conforme l'au moins un trou traversant (5) avec du cuivre (8) en une étape,
dans lequel le cuivre (8) est déposé électrolytiquement à l'étape d. à partir d'un bain de cuivrage aqueux acide comprenant 12 à 20 g/l d'ions ferreux et 2 à 6 g/l d'ions ferriques par dépôt en courant pulsé inverse comprenant un premier cycle d'au moins une impulsion directe, la durée de l'au moins une première impulsion directe se situant dans la gamme de 2 à 40 ms, et d'au moins une impulsion inverse, la durée de l'au moins une première impulsion inverse se situant dans la gamme de 2 à 8 ms, et un deuxième cycle d'au moins une impulsion directe, la durée de l'au moins une impulsion directe dans le deuxième cycle se situant dans la gamme de 2 à 40 ms, et d'au moins une impulsion inverse, la durée de l'au moins une impulsion inverse dans le deuxième cycle se situant dans la gamme de 1 à 4 ms, appliqué en une seule passe d'équipement de dépôt, et dans lequel les paramètres de dépôt en courant pulsé inverse appliqués à l'étape d. comprennent dans le premier cycle une densité de courant maximale d'au moins une première impulsion directe dans la gamme de 3 à 7 A/dm² et une densité de courant maximale d'au moins une première impulsion inverse dans la gamme de 20 à 40 A/dm².

2. Procédé de cuivrage selon la revendication 1 dans lequel le cuivre (8) est déposé électrolytiquement à l'étape d. à partir d'un bain de cuivrage aqueux acide comprenant
• une source d'ions cuivre
• un acide
• au moins un additif brillanteur organique
• au moins un additif nivelant organique en présence d'au moins une anode inerte.

3. Procédé de cuivrage selon la revendication 2 dans lequel la concentration de l'au moins un additif brillanteur va de 0,01 à 100 mg/l.

4. Procédé de cuivrage selon l'une quelconque des revendications 2 à 3 dans lequel la concentration de l'au moins un additif nivelant va de 0,1 à 100 mg/l.

5. Procédé de cuivrage selon l'une quelconque des revendications précédentes dans lequel les paramètres de dépôt en courant pulsé inverse appliqués à l'étape d. comprennent en outre dans un deuxième cycle une densité de courant maximale d'au moins une impulsion directe dans la gamme de 4 à 10 A/dm² et une densité de courant maximale d'au moins une impulsion inverse dans la gamme de 0 à 20 A/dm².

6. Procédé de cuivrage selon l'une quelconque des revendications précédentes dans lequel la durée du premier cycle va de 20 à 160 ms.

7. Procédé de cuivrage selon l'une quelconque des revendications précédentes dans lequel la durée du deuxième cycle va de 2 à 160 ms.

8. Procédé de cuivrage selon l'une quelconque des revendications précédentes dans lequel des trous traversants et des microtrous d'interconnexion borgnes sont formés à l'étape b. par un procédé choisi parmi le perçage mécanique, le perçage laser, la gravure par plasma et l'électro-érosion.
